# EUROPEAN PATENT APPLICATION

(11) **EP 4 050 351 A1**
(43) Date of publication of application: **31.08.2022**
(21) Application number: 21159178.9
(22) Date of filing: 25.02.2021
(51) Int. Cl.: G01R 27/20, F03D 17/00, G01R 31/11, G01R 31/52

(54) **METHOD OF MONITORING THE INTEGRITY OF A GROUND NETWORK**

(71) Applicant: Siemens Gamesa Renewable Energy A/S, 7330 Brande (DK)
(72) Inventor: Devaraj, Aravind, 682030 Kochi (IN); George, Ajoe, 686004 Kerala (IN); K, Rachana Raj, 560010 Karnataka (IN); R, Aswin, 673521 CALICUT (IN); Sulaiman, Sajeesh, 560087 Bangalore (IN)
(74) Representative: Aspacher, Karl-Georg

(57) **Abstract**

The invention describes a method of monitoring a ground network (GN) of a number of electrical circuits (E) of a wind turbine (2), which method comprises the steps of locating a ground connector (GC) electrically connected to the ground network (GN); injecting a test signal (S) into the ground connector (GC); recording the reflection (S_{R}) of the injected test signal (S); and evaluating the reflected test signal (S_{R}) to deduce the health status of the ground network (GN). The invention further describes a ground network monitoring arrangement (1) and a method of calibrating such a ground network monitoring arrangement (1).

## Description

The invention describes a method of monitoring the integrity of a ground network in a wind turbine; and a ground connection monitoring arrangement.

### Background

Electrical systems in a wind turbine are connected to ground (earth) for several reasons. For example, exposed metal parts of electrical equipment are connected to ground, so that failures of internal insulation will trigger protective mechanisms such as fuses or circuit breakers in the circuit to remove power from the device. This ensures that exposed parts can never have a dangerous voltage with respect to ground, which could cause an electric shock to personnel.

The electrical connection to ground can also limit the undesirable build-up of static electricity, which is particularly relevant during the handling of flammable products or electrostatic-sensitive devices (ESDs).

In a wind turbine, there may be several functionally separate electrical systems (not including the lightning protection system). For example, in addition to its electrical generator, a wind turbine may have a cooling system, a ventilation system, an interior lighting system, an exterior lighting system, a winch system, a control system, etc. Any such system may be electrically connected to earth by means of a protective earth (PE) conductor which is physically connected to a metal structure leading to ground. It is necessary to ensure that any path to electrical ground remains "healthy", i.e. that the electrical circuit is reliably connected to earth at all times.

However, during the lifetime of a component or system, a cable may become loose or may suffer damage from impact, corrosion, etc. Fasteners such as clamps or nuts used to secure a ground cable may become loose over time. Therefore, it is necessary to regularly inspect the ground connectors in a wind turbine in order to reduce the risk of injury and also to avoid damage to the systems.

A wind turbine may have several hundred ground cables, all of which need to be inspected. One approach would be to include design measures to ensure access to each ground cable of the many electrical systems and circuits. However, such design measures would add significantly to the overall cost of the wind turbine, since there may be several hundred such cables. In any case, it may not always be feasible to allow physical access to each ground cable. Furthermore, even if the several hundred ground cables were accessible to a technician, it would take a prohibitive length of time to locate and test each one.

It is therefore an object of the invention to provide a more economical and straightforward way of inspecting ground connections of a wind turbine.

This object is achieved by the method of claim 1 of monitoring the integrity of a ground network in a wind turbine; and by the ground connection monitoring arrangement of claim 8.

### Description

The inventive method provides a way of monitoring the integrity of any ground connection of any electrical circuit in a wind turbine. According to the invention, the method comprises the steps of locating a ground connector electrically connected to the ground network; injecting a test signal into the ground connector; recording the reflection of the injected test signal; and evaluating the reflected test signal to deduce the health status of the ground network.

The term "ground connector" shall be understood in the conventional sense to mean a robust physical connection to electrical earth, e.g. an earthing cable. Such an earthing cable may comprise a thick copper cable enclosed in an insulating sheath, with metal connectors or tabs at either end for connecting the cable between the grounding network and a further conductor leading to earth. The skilled person will be familiar with the usual type of thick PE cable used to ground the electrical systems of a wind turbine. In the context of the invention, a "ground connector" shall not be confused with the relatively thin earthing wire or cable of an electrical device or appliance. The earthing wires (identifiable by a green/yellow isolating sheath) of various appliances can be joined collectively as part of a grounding network, and various grounding networks can converge at a ground connector or thick PE cable.

The invention is based on the insight that an assessment of the integrity of the ground network - i.e. all earthing connections of one or more electrical systems - can be obtained through a ground connector such as a PE cable. The invention takes the approach of injecting a specific test signal (with well-defined properties) into the PE cable, measuring the reflection of the test signal, and comparing the reflection to an expected result. In the following, the terms "reflected test signal" and "reflection" may be used interchangeably. Since the ground network is well-defined, and since ideally it should not change over time, any deterioration or fault in the ground network will manifest as a discrepancy between an expected reflection and the actual reflection.

An advantage of the inventive method is that there is no need to configure an electrical system to allow access to each of its (possibly many) ground cables. Instead, the inventive method only requires access to a "low level" ground connector, for example a PE cable bolted or clamped to an easily accessible metal structure of the wind turbine. The ground network of one or more electrical systems and circuits may be grounded by electrically connecting any wires, cables, or terminals of the ground network to a PE cable, which in turn may be bolted or clamped to a generator bedframe, the nacelle canopy, a metal tower platform, or similar. Access to such a PE cable is sufficient for carrying out the inventive method, since each ground PE cable gives access to the ground network, i.e. to the network of earthing connections originating from the various electrical systems and circuits.

Another advantage of the inventive method is the significant savings in time. Instead of laboriously locating and testing each individual ground cable or terminal at the various components, cabinets and other structures inside the wind turbine, it is sufficient to locate the common ground connectors such as the PE cables mentioned above, and to inject a test signal into each ground connector. Each reflected test signal can then be evaluated to determine the health of the ground network "behind" that PE cable. An exemplary wind turbine with several hundred ground wires, cables and terminals in its electrical systems and circuits may deploy only a few such shared PE cables, for example 10 - 20. Each PE cable may be assumed to be the collective ground for a plurality of electrical systems; each electrical system may be assumed to comprise several sub-systems or circuits. The inventive method of performing continuity diagnostics of the ground networks requires access only to these few PE cables, allowing the integrity of every ground network to be tested in a fraction of the time that would be required by the conventional approach of individually testing several hundred connections.

According to the invention, the ground connection monitoring arrangement comprises a signal generator configured to generate a test signal; a means of injecting a test signal into a ground connector electrically connected to the ground network of a number of electrical circuits of a wind turbine; a means of recording the reflected test signal; and an evaluation module configured to deduce the health status of the ground network on the basis of the reflected test signal.

The invention also describes a method of calibrating such a ground network monitoring arrangement. According to the invention, the method comprises the steps of locating a ground connector that is electrically connected to a ground network of a number of electrical circuits of a wind turbine; injecting a test signal into the ground connector and recording its reflection; comparing the injected signal to the reflected test signal; and storing the results of the comparison as calibration data for that ground network.

Particularly advantageous embodiments and features of the invention are given by the dependent claims, as revealed in the following description. Features of different claim categories may be combined as appropriate to give further embodiments not described herein.

In the following, it may be assumed that a wind turbine comprises various electrical systems, circuits, etc. and that various ground networks are connected - electrically and physically - to earthed structures by means of ground connectors or PE cables.

A reflection measured at a PE cable can be evaluated in a number of ways. In a preferred embodiment of the invention, the method comprises a step of obtaining reference data from a database. This reference data may comprise calibration data obtained during a calibration procedure, preferably performed before commissioning of the wind turbine. Equally, the reference data may describe signal properties that may be expected at a certain stage in the lifetime of the wind turbine. Reference data preferably comprises a number of expected parameter values for a reflected test signal, for example one or more time-domain features (e.g. a peak-to-peak amplitude, a delay or time-of-flight, and/or an attenuation) and/or one or more frequency-domain features (e.g. phase, phase-shift, and/or discrete Fourier coefficients). Parameter values can be determined by time-domain and/or frequency-domain processing of the reflected signal, and the skilled person will be familiar with suitable signal processing techniques.

To obtain such reference data, the evaluation module is preferably in communication with a database in which reference data (expected parameters) are stored for a specific test signal, for example parameters that would be expected for a Gaussian pulse test signal, a rectangular pulse test signal, a sinusoidal test signal, etc. The database may store a set of expected parameters for each of several test signals. Equally, the database may store a set of expected parameters for a specific PE cable of a specific wind turbine type, since each PE cable of a specific wind turbine type will be connected to a known (i.e. well-defined) ground network.

The reflected test signal is preferably evaluated by comparing a parameter value of the reflected test signal to an expected parameter value. The amount by which the measured parameter values differ from the expected values can be used to quantify the health status of the ground network. For example, if a measured parameter value is within a predefined percentage of the corresponding expected parameter value, the ground network may be deemed to be intact or "healthy". On the other hand, if the measured parameter value differs by more than a predefined amount from the corresponding expected parameter value, the ground network may be deemed to be unreliable, so that a maintenance procedure would be scheduled to locate the precise location of the fault and to remedy the fault. Of course, an integrity test may compare a set of measured parameter values to a corresponding set of expected parameter values, and the ground network may be regarded as "healthy" if the measured values are collectively within a certain percentage of the expected parameter values, or "faulty" if the measured values collectively differ by more than a certain percentage from the expected parameter values, for example.

The integrity of the ground network can be tested at intervals during the lifetime of the wind turbine, for example during the regular inspection procedures.

In a further preferred embodiment of the invention, the method comprises a step of storing a deduced health status in a database. This can be the same database that is used to store the reference data. Keeping track of the results of ground network monitoring may facilitate the identification and repair of electrical faults later on.

A wind turbine may comprise several distinct electrical systems, each with a ground network connected to a PE cable, and the steps of the method are carried out successively for each of the plurality of PE cables. For example, the electrical systems of a wind turbine can be organised in groups according to their locations, for example in the hub, the generator, the nacelle, the tower, etc. Each group can be configured so that its ground network - i.e. the network of ground wires, cables and terminals of all circuits in that group - is connected to a specific PE cable. A pristine PE cable that is correctly secured at both ends is essentially part of the ground network from the point of view of the inventive method.

The evaluation module is preferably configured to establish the location of a fault in the ground network. This can be done with the aid of calibration data, for example by identifying a critical ground connection between an electrical circuit and its PE cable, interrupting that connection, injecting a test signal into the PE cable, and recording the reflected test signal. The deliberate open circuit leaves its "fingerprint" on the reflected signal, and this can be compared later on to measured reflection. If the measured reflection appears similar to the "open circuit" reflection, this can be interpreted as an actual fault in the corresponding electrical circuit.

As mentioned above, any calibration step is preferably performed before the wind turbine is commissioned, since it can safely be assumed that all ground networks are intact and fully reliable. Of course, calibration of the inventive monitoring arrangement can be performed at any stage during the lifetime of a wind turbine, for example on a wind turbine that is already operational, and is preferably preceded by a step of ensuring that each ground network is healthy. Equally, a re-calibration of the inventive monitoring arrangement may be performed whenever an electrical system is modified, for example after replacement or repair of a faulty electrical unit or subsystem.

The monitoring arrangement may be portable, i.e. a technician can carry the monitoring arrangement into a wind turbine and use it to successively inject test signals into the various PE cables and to evaluate the results. The portable monitoring arrangement may comprise a module with a database storing appropriate reference data in order to be able to evaluate the reflected signals. Equally, such a portable monitoring arrangement may by realised to communicate with a remote database, e.g. to transmit the measured parameters to a remote evaluation module. Alternatively, the monitoring arrangement may be installed permanently in the wind turbine by providing electrical connections between a signal generator and the various PE cables. The evaluation module can be realised as part of the wind turbine controller, or as part of a remote park controller, for example. The advantage of a permanently installed monitoring arrangement is that an integrity test can be carried out at any time. Equally, a calibration procedure can also be carried out at any time.

Other objects and features of the present invention will become apparent from the following detailed descriptions considered in conjunction with the accompanying drawings. It is to be understood, however, that the drawings are designed solely for the purposes of illustration and not as a definition of the limits of the invention.
Figure 1 shows an embodiment of the inventive ground network monitoring arrangement;
Figure 2 is a schematic diagram of a wind turbine;
Figure 3 is single-line diagram showing electrical systems relative to earthed conductive in the wind turbine of Figure 2.

In the diagrams, like numbers refer to like objects throughout. Objects in the diagrams are not necessarily drawn to scale.

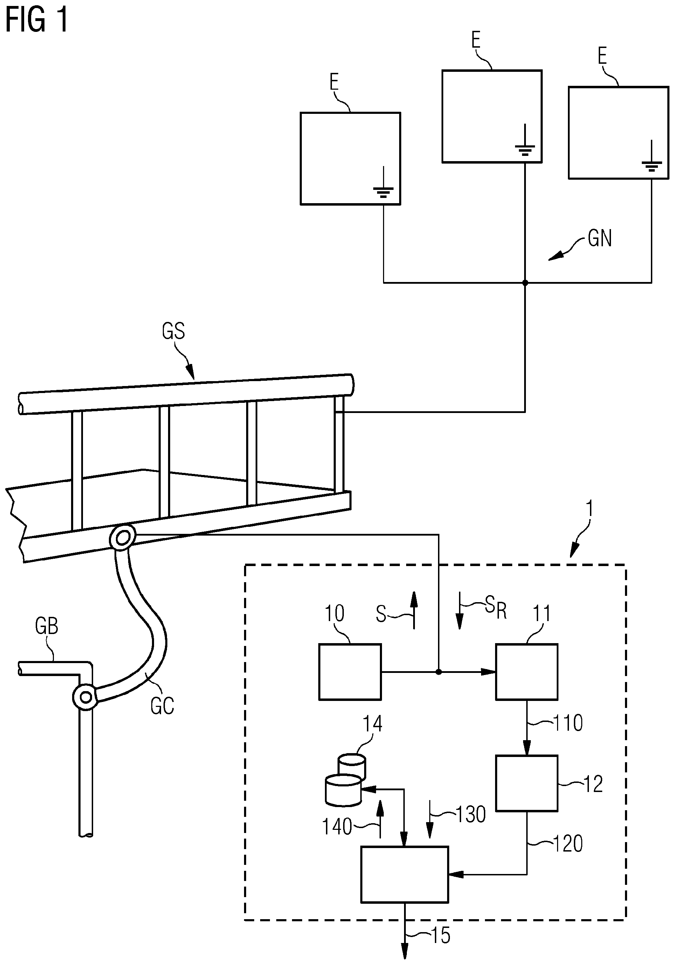

Figure 1 shows an exemplary embodiment of the inventive ground network monitoring arrangement 1 connected to inject a test signal S into a grounding cable GC or PE cable, which in turn provides an electrical and physical connection between a ground network GN of a group of electrical modules E and a grounding structure GS such as a metal bedframe, platform, nacelle canopy etc. One end of the grounding cable GC can be fastened to the grounding structure GS, and the other end may be fastened to a grounding bar GB or earth bar. The integrity test can be carried out without first opening an isolation device.

The monitoring arrangement 1 comprises a signal generator 10 which can generate a suitable test signal S such as a Gaussian pulse, for example. The pulse duration can be very brief, for example a few milliseconds.

The test signal S is applied to the grounding cable GC, either directly or by connection to the conductive grounding structure GS. The test signal S will travel into the ground network GN and will undergo partial reflection, becoming distorted to some extent before returning for detection by a receiver 11. For example, if the injected signal is a wide-spectrum Gaussian pulse (with many component frequencies, from low to high), the reflected signal S_{R} will exhibit several peaks, distorted and delayed in a manner that is characteristic of the ground network that caused its reflection.

The reflection S_{R} is recorded, for example using a suitable sampling technique, and the sampled signal 110 is then processed in a processing unit 12 which is configured to extract relevant time-domain and/or frequency-domain features 120 that describe the reflected signal. Information extracted from a signal reflected back to source is generally referred to as the "S11 parameters", and these deliver useful information that is characteristic of the electrical circuit that reflected the signal. When compared to reference data 140 previously obtained for the circuit in a known "healthy" state, the S11 parameters 120 can indicate whether part of the ground network is faulty, which can occur if a cable or wire has become loosened, damaged or cracked. This evaluation is performed in the evaluation module 13 of the monitoring arrangement 1 using appropriate algorithms. As explained above, any deviation from S11 parameters 140 of an earlier recorded calibration measurement can indicate degradation of one or more connections in the ground network GN. Further analysis can be done to estimate the extent of degradation and to assess the need for remedial action.

In this exemplary embodiment, a database 14 with reference data 140 is shown in communication with the evaluation module 13. Communication can be wireless, so that the database 14 can be at a remote location. The database 14 can store calibration data 140 obtained for that ground network GN during a calibration stage. The database 14 can also store data 130 provided by the evaluation unit 13, for example any S11 parameters 120 collected during the lifetime of that ground network GN and/or the health status of that ground network GN.

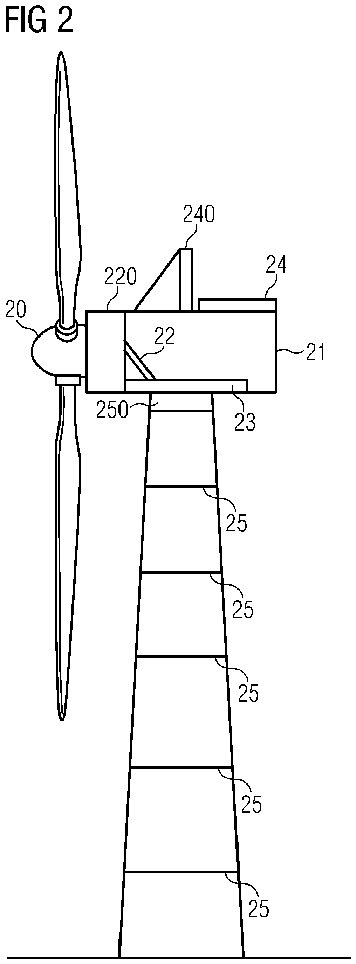

Figure 2 is a schematic diagram of a wind turbine 2. A few of the major electrical systems - generator 220, cooling arrangement 240, yaw system 250 - are shown, and it shall be understood that the wind turbine may have many more electrical systems, for example a ventilation system, power converter, control systems, pitch systems, elevator system, lighting systems, etc. The ground wires, cables, terminals etc. of several electrical systems arranged in a specific location can be collectively connected in a ground network, which is earthed by a PE cable of the type shown in Figure 1. PE cables can be electrically and physically connected to any earthed conductive structure (a grounding structure GS as shown in Figure 1) such as the hub 20, the nacelle canopy 21, a generator bedframe 22, a nacelle platform 23, a heli-hoist platform 24, a tower platform 25, etc.

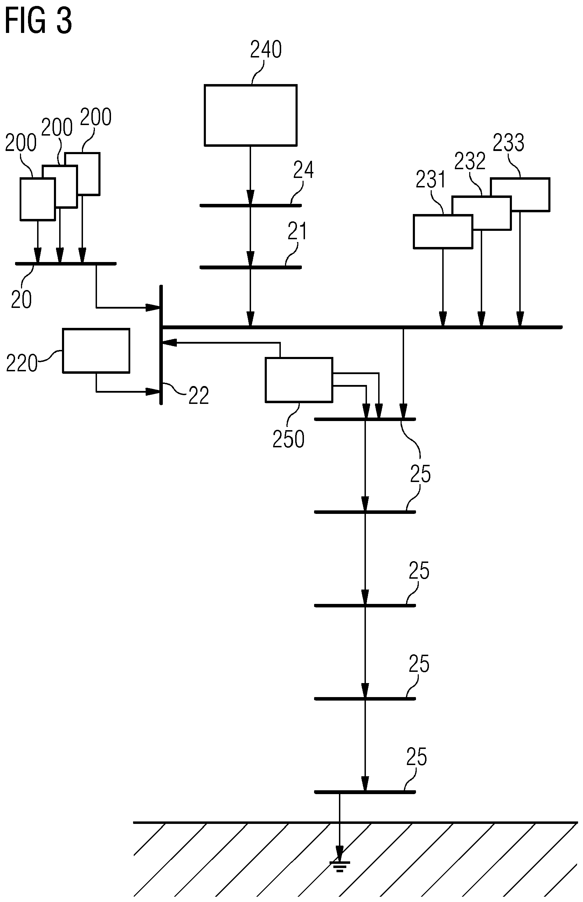

Figure 3 is a type of single-line diagram to indicate various electrical systems relative to various conductive grounding structures 20, 21, 22, 23, 24, 25 indicated by the thick straight lines. Any of these conductive structures 20, 21, 22, 23, 24, 25 is represented in Figure 1 by the grounding structure GS, and each of these ultimately leads to ground. Each earthing network of one or more electrical systems is electrically and physically connected to a conductive grounding structure by means of a thick cable or ground connector GC of Figure 1 so that the wind turbine complies with the relevant regulations. In this exemplary embodiment, rotor blade pitch systems 200 are earthed by the hub 20; a cooling system 240 is earthed by the heli-hoist platform 24 and the canopy 21, electrical systems 231, 232, 233 in the nacelle are earthed by the nacelle floor plate 23; the generator 220 is earthed by the generator bedframe 22, the yaw system 250 is earthed by a tower platform 25; etc. A current path to electrical earth (usually below the tower foundation) is provided through all levels 25 of the tower.

In the case of a portable monitoring arrangement 1, a technician can attach the signal generator 10 to a grounding connector GC at any one of these conductive structures in order to test a ground network through that grounding connector GC.

In the case of a permanently installed monitoring arrangement 1, the signal generator 10 and detector 11 can be electrically connected to any such grounding connector GC in order to be able to test any ground network GN at any time.

Although the present invention has been disclosed in the form of preferred embodiments and variations thereon, it will be understood that numerous additional modifications and variations could be made thereto without departing from the scope of the invention.

For the sake of clarity, it is to be understood that the use of "a" or "an" throughout this application does not exclude a plurality, and "comprising" does not exclude other steps or elements. The mention of a "unit" or a "module" does not preclude the use of more than one unit or module.

## Claims

1. A method of monitoring a ground network (GN) of a number of electrical circuits (E) of a wind turbine (2), which method comprises the steps of
- locating a ground connector (GC) electrically connected to the ground network (GN);
- injecting a test signal (S) into the ground connector (GC) ;
- recording the reflection (S_{R}) of the injected test signal (S); and
- evaluating the reflected test signal (S_{R}) to deduce the health status of the ground network (GN).

2. A method according to claim 2, comprising a step of obtaining reference data (140) from a database (14), which reference data (140) comprises a number of expected parameter values for a reflected test signal (S_{R}).

3. A method according to any of the preceding claims, wherein the step of evaluating the reflected test signal (S_{R}) comprises comparing a parameter value of the reflected test signal (S_{R}) to an expected parameter value.

4. A method according to any of the preceding claims, wherein a parameter is any of: a peak-to-peak amplitude, a delay, an attenuation, a phase, a phase-shift, a discrete Fourier coefficient.

5. A method according to any of the preceding claims, wherein the steps of the method are carried out at intervals during the lifetime of the wind turbine (2).

6. A method according to any of the preceding claims, comprising a step of recording the deduced health status of a ground network (GN) in a database.

7. A method according to any of the preceding claims, wherein the wind turbine (2) comprises a plurality of electrical systems (E), each with a ground network (GN) connected to electrical earth via a ground connector (GC), and the steps of the method are carried out successively for each of the plurality of ground connectors (GC).

8. A ground network monitoring arrangement (1) comprising
- a signal generator (10) configured to generate a test signal (S);
- a means of injecting a test signal (S) into a ground connector (GC) electrically connected to the ground network (GN) of a number of electrical circuits (E) of a wind turbine (2);
- a receiver (11) configured to record a reflected test signal (S_{R}); and
- an evaluation module (13) configured to deduce the health status of the ground network (GN) on the basis of the reflected test signal (S_{R}).

9. A ground network monitoring arrangement according to claim 8, wherein the evaluation module (13) is in communication with a database (14) of reference data (140) for a reflected test signal (S_{R}).

10. A ground network monitoring arrangement according to claim 8 or claim 9, wherein the evaluation module (13) is configured to establish the location of a fault in the ground network (GN).

11. A method of calibrating a ground network monitoring arrangement (1) according to any of claims 8 to 10, comprising the steps of
- locating a ground connector (GC) electrically connected to a ground network (GN) of a number of electrical circuits (E) of a wind turbine (2);
- injecting a test signal (S) into the ground connector (GC) and recording its reflection (S_{R});
- comparing the injected signal (S) to the reflected test signal (S_{R}); and
- storing the results of the comparison as calibration data (D) for that ground network (GN).

12. A calibration method according to claim 11, wherein calibration is performed prior to commissioning the wind turbine (2).

13. A calibration method according to claim 11 or claim 12, wherein calibration is performed following a re-configuration of any electrical system (E) connected to a ground connector (GC) .
